# EUROPEAN PATENT SPECIFICATION

(11) **EP 4 386 401 B1**
(45) Date of publication and mention of the grant of the patent: **02.09.2026**
(21) Application number: 22856069.4
(22) Date of filing: 27.07.2022
(51) Int. Cl.: G01R 31/367, G01R 31/36, G01R 31/382, G01R 31/392, G01R 19/165, G06N 20/00, H01M 10/48, H01M 10/42, B60L 58/10, G06N 3/044

(54) **BATTERY MANAGEMENT APPARATUS AND BATTERY TESTING SYSTEM INCLUDING THE SAME**
BATTERIEMANAGEMENTVORRICHTUNG UND BATTERIETESTSYSTEM DAMIT
DISPOSITIF DE GESTION DE BATTERIE ET SYSTEME DE TEST DE BATTERIE LE COMPRENANT

(30) Priority: 13.08.2021 KR 20210107250
(43) Date of publication of application: 19.06.2024
(73) Proprietor: LG Energy Solution, Ltd., Seoul 07335 (KR)
(72) Inventor: LEE, Jung Hoon, Daejeon 34122 (KR)
(74) Representative: Goddar, Heinz J.
(86) International application number: PCT/KR2022/011061
(87) International publication number: WO 2023/018070

(56) References cited:
- JP-A- 2018 530 982
- JP-B2- 6 513 881
- KR-A- 20200 023 672
- KR-A- 20200 058 998
- KR-A- 20200 119 383
- KR-A- 20210 024 962
- KR-A- 20210 024 962
- KR-B1- 102 239 040
- US-A1- 2016 018 472

## Description

### [TECHNICAL FIELD]

### CROSS-REFERENCE TO RELATED APPLICATION

This application claims priority to and the benefit of Korean Patent Application No. 10-2021-0107250 filed in the Korean Intellectual Property Office on August 13, 2021.

### TECHNICAL FIELD

Embodiments disclosed herein relate to a battery management apparatus and a battery testing system including the same.

### [BACKGROUND ART]

An electric vehicle is supplied with electricity from outside to charge a battery, and then a motor is driven by a voltage charged in the battery to obtain power. The battery of the electric vehicle may have heat generated therein by chemical reaction occurring in a process of charging and discharging electricity, and the heat may impair performance and lifetime of the battery. Thus, a battery management apparatus (or a battery management system (BMS)) that monitors temperature, voltage, and current of the battery is driven to diagnose the state of the battery.

However, when high-performance GPU or NPU is mounted on the battery management apparatus to precisely analyze the state of the battery in real time, the efficiency of the battery management apparatus is degraded and the cost of the battery management apparatus increases. Moreover, when the entire battery data measured by the battery management apparatus is transmitted to a cloud server for analysis, infra installation cost and communication cost incur and efficiency is degraded in a process of managing and analyzing a lot of data.

KR 20210024962 A describes a device and method for diagnosing the state and predicting the lifespan of Energy Storage System (ESS) batteries, using a deep learning-based diagnostic prediction model.

### [DISCLOSURE]

### [TECHNICAL PROBLEM]

Embodiments disclosed herein aim to provide a battery management apparatus and a battery testing system including the same, in which only data of a battery determined to be in an anomaly situation is precisely analyzed, thereby improving the efficiency of the battery management apparatus and reducing infra installation cost and communication cost.

Technical problems of the embodiments disclosed herein are not limited to the above-described technical problems, and other unmentioned technical problems would be clearly understood by one of ordinary skill in the art from the following description.

### [TECHNICAL SOLUTION]

A battery management apparatus according to an embodiment disclosed herein includes a first controller configured to obtain state data including a measurement value resulting from measuring a state of a battery, a second controller configured to generate prediction data for predicting the state of the battery by applying measurement values in past times and at least a part of measurement values in a current time of the state data to machine learning and to determine the state of the battery based on a result of comparing the prediction data with the state data of the battery, and a communication unit configured to transmit the state data to a server only in case that the battery is determined to be in an anomaly state based on a result of determining the state of the battery.

According to an embodiment, the second controller may be further configured to compress the state data obtained for a predetermined time before and after when the battery is determined to be in the anomaly state, in case that the battery is determined to be in the anomaly state.

According to an embodiment, the communication unit may be further configured to transmit the compressed state data of the battery to the server.

According to an embodiment, the measurement value may include voltage, current, and temperature of the battery, which are measured cumulatively, and the state data may include the measurement value and a state of health (SOH) of the battery, calculated based on the measurement value.

According to an embodiment, the prediction data may include a voltage of the battery, and the second controller may be further configured to predict the voltage of the battery by applying past data included in the state data and current and temperature of the battery, which are included in the state data and measured at current time, to the machine learning model.

According to an embodiment, the second controller may be further configured to predict the voltage of the battery by applying the state data to a long short term memory (LSTM) algorithm.

According to an embodiment, the second controller may be further configured to generate an anomaly score by applying the state data and the prediction data to an anomaly detection algorithm.

According to an embodiment, the second controller may be further configured to determine the battery to be in the anomaly state when a rate of anomaly scores equal to or greater than a threshold value among anomaly values generated for a predetermined time is equal to or greater than a specific rate.

A battery testing system according to an embodiment disclosed herein includes a battery management apparatus according to an embodiment and a server configured to determine whether the battery is in an anomaly state, based on the state data of the battery.

According to an embodiment, the battery management apparatus may be further configured to compress the state data obtained for a predetermined time before and after when the battery is determined to be in an anomaly state, and to transmit the compressed state data to the server, in case that the battery is determined to be in the anomaly state.

According to an embodiment, the measurement value may include voltage, current, and temperature of the battery, which are measured cumulatively, and the state data may include the measurement value and an SOH of the battery, calculated based on the measurement value.

According to an embodiment, the battery management apparatus may be further configured to predict the voltage of the battery by applying past data included in the state data and current and temperature of the battery, which are included in the state data and measured at current time, to an LSTM algorithm.

According to an embodiment, the battery management apparatus may be further configured to generate an anomaly score by applying the state data and the prediction data to an anomaly detection algorithm, and to determine the battery to be in the anomaly state when a rate of anomaly scores equal to or greater than a threshold value among anomaly values generated for a predetermined time is equal to or greater than a specific rate.

According to an embodiment, the server may be further configured to extract false alarm when the battery is determined to be in the anomaly state in the battery management apparatus even though the battery is not actually in the anomaly state.

According to an embodiment, the server may be further configured to measure the SOH value of the battery and the threshold value of the anomaly detection algorithm and to transmit the SOH value and the threshold value to the battery management apparatus, when a frequency of the false alarm is equal to or greater than a threshold frequency.

According to an embodiment, the battery management apparatus may be further configured to update the LSTM algorithm and the anomaly detection algorithm based on the SOH value and the threshold value, received from the server.

### [ADVANTAGEOUS EFFECTS]

With a battery management apparatus and a battery testing system including the same according to an embodiment disclosed herein, only data of a battery determined to be in an anomaly situation may be precisely analyzed to improve the efficiency of the battery management apparatus and reduce infra installation cost and communication cost.

### [DESCRIPTION OF DRAWINGS]

FIG. 1 illustrates a configuration of a battery pack according to an embodiment disclosed herein.
FIG. 2 is a block diagram illustrating a configuration of a battery management apparatus, according to an embodiment disclosed herein.
FIG. 3 is a view for generally describing a battery management apparatus according to an embodiment disclosed herein.
FIG. 4 is a block diagram illustrating a configuration of a battery testing system according to an embodiment disclosed herein.
FIG. 5 is a flowchart illustrating an operating method of a battery testing system according to an embodiment disclosed herein.

### [MODE FOR INVENTION]

Hereinafter, some embodiments disclosed in this document will be described in detail with reference to the exemplary drawings. In adding reference numerals to components of each drawing, it should be noted that the same components are given the same reference numerals even though they are indicated in different drawings. In addition, in describing the embodiments disclosed in this document, when it is determined that a detailed description of a related known configuration or function interferes with the understanding of an embodiment disclosed in this document, the detailed description thereof will be omitted.

To describe a component of an embodiment disclosed herein, terms such as first, second, A, B, (a), (b), etc., may be used. These terms are used merely for distinguishing one component from another component and do not limit the component to the essence, sequence, order, etc., of the component. The terms used herein, including technical and scientific terms, have the same meanings as terms that are generally understood by those skilled in the art, as long as the terms are not differently defined. Generally, the terms defined in a generally used dictionary should be interpreted as having the same meanings as the contextual meanings of the relevant technology and should not be interpreted as having ideal or exaggerated meanings unless they are clearly defined in the present document.

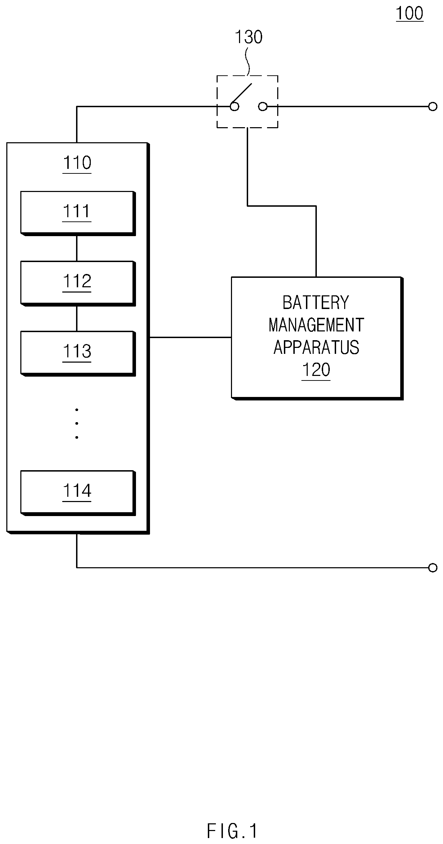

FIG. 1 illustrates a battery pack according to an embodiment disclosed herein.

Referring to FIG. 1, a battery pack 100 according to an embodiment disclosed herein may include a battery module 110, a battery management apparatus 120, and a relay 130.

The battery module 110 may include a first battery cell 111, a second battery cell 112, a third battery cell 113, and a fourth battery cell 114. Although the plurality of battery cells are illustrated as four in FIG. 1, the present invention is not limited thereto, and the battery module 110 may include n battery cells (n is a natural number equal to or greater than 2).

The battery module 110 may supply power to a target device (not shown). To this end, the battery module 110 may be electrically connected to the target device. Herein, the target device may include an electrical, electronic, or mechanical device that operates by receiving power from the battery pack 100 including the plurality of battery cells 111, 112, 113, and 114, and the target device may be, for example, an electric vehicle (EV), but is not limited thereto.

The battery cell 111 may be a lithium ion (Li-ion) battery, an Li-ion polymer battery, a nickel-cadmium (Ni-Cd) battery, a nickel hydrogen (Ni-MH) battery, etc., and may not be limited thereto. Meanwhile, although one battery module 110 is illustrated in FIG. 1, the battery module 110 may be configured in plural according to an embodiment.

The battery management apparatus (or a battery management system (BMS)) 120 may manage and/or control a state and/or an operation of the battery module 110. For example, the battery management apparatus 120 may manage and/or control the states and/or operations of the plurality of battery cells 111, 112, 113, and 114 included in the battery module 110. The battery management apparatus 120 may manage charging and/or discharging of the battery module 110.

In addition, the battery management apparatus 120 may monitor a voltage, a current, a temperature, etc., of the battery module 110 and/or each of the plurality of battery cells 111, 112, 113, and 114 included in the battery module 110. A sensor or various measurement modules for monitoring performed by the battery management apparatus 120, which are not shown, may be additionally installed in the battery module 110, a charging/discharging path, any position of the battery module 110, etc. The battery management apparatus 120 may calculate a parameter indicating a state of the battery module 110, e.g., a state of charge (SOC), a state of health (SOH) etc., based on a measurement value such as monitored voltage, current, temperature, etc.

The battery management apparatus 120 may control an operation of the relay 130. For example, the battery management apparatus 120 may short-circuit the relay 130 to supply power to the target device. The battery management apparatus 120 may short-circuit the relay 130 when a charging device is connected to the battery pack 100.

The battery management apparatus 120 may calculate a cell balancing time of each of the plurality of battery cells 111, 112, 113, and 114. Herein, the cell balancing time may be defined as a time required for balancing of the battery cell. For example, the battery management apparatus 120 may calculate a cell balancing time based on an SOC, a battery capacity, and a balancing efficiency of each of the plurality of battery cells 111, 112, 113, and 114.

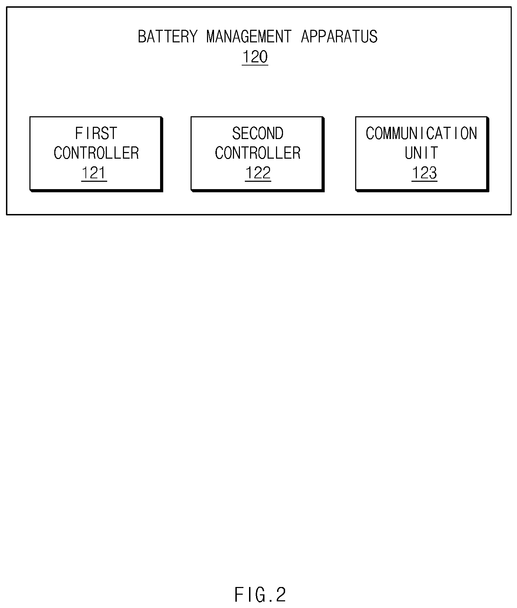

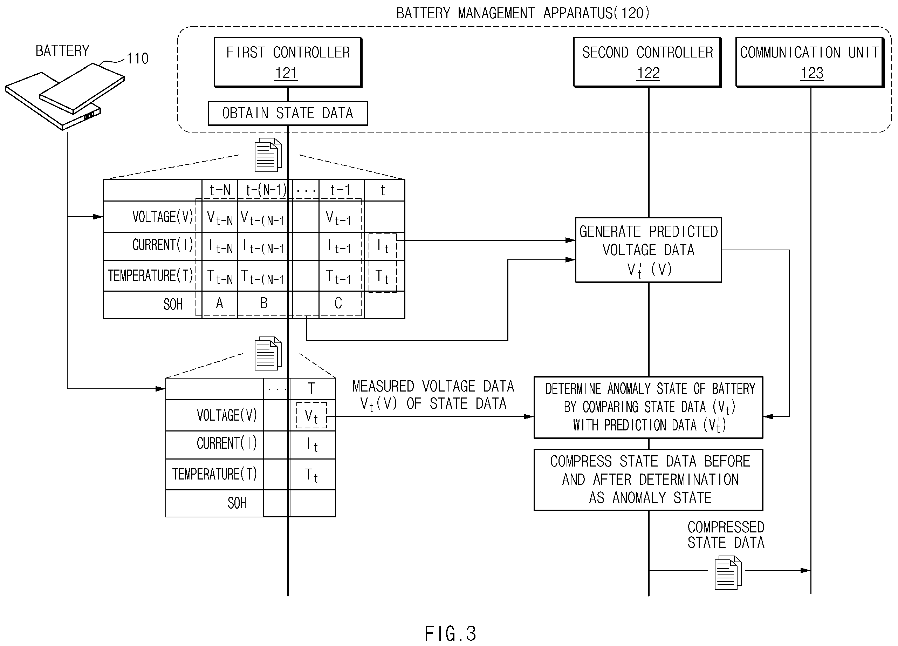

Hereinbelow, referring to FIGS. 2 and 3, a configuration and an operating method the battery management apparatus 120 will be described.

FIG. 2 is a block diagram illustrating a configuration of a battery management apparatus, according to an embodiment disclosed herein. FIG. 3 is a view for generally describing a battery management apparatus according to an embodiment disclosed herein.

Referring to FIG. 2, the battery management apparatus 120 may include a first controller 121, a second controller 122, and a communication unit 123.

In FIG. 2, the battery module 110 may include the plurality of battery cells 111, 112, 113, and 114, but the first battery cell 111will be described as an example below.

Referring to FIG. 3, the first controller 121 may obtain state data including a measurement value resulting from measuring the state of the first battery cell 111. Herein, the measurement value may include voltage, current, and temperature of the first battery cell 111 measured cumulatively. For example, the state data may include the measurement value including the measured voltage, current, and temperature of the first battery cell 111 and a state of health (SOH) of the first battery cell 111 calculated based on the measurement value.

For example, the first controller 121 may obtain a measurement value resulting from measuring voltage, current, and temperature of the first battery cell 111 from time (t-N) to time (t-1), and obtain an SOH of the first battery cell 111 from the time (t-N) to the time (t-1) based on the measurement value. Herein, N may be defined as a constant value indicating a variation of a variable t indicating time.

For example, the first controller 121 may obtain a voltage *V_{t-N}*, a current *I_{t-N}*, and a temperature *T_{t-N}* of the first battery cell 111 at the time (t-N) to obtain an SOH value of the first battery cell 111 at the time (t-N), and obtain a voltage *V*_{*t-*(*N-*1)}*,* a current *I*_{*t-*(*N*-1)}*,* and a temperature *T*_{*t-(N*-1)} of the first battery cell 111 at time (t-(N-1)) to obtain an SOH value of the first battery cell 111 at the time (t-(N-1)). That is, the first controller 121 may obtain past state data of the first battery cell 111 from the time (t-N) to the time (t-1).

The first controller 121 may obtain a measurement value of a current *Iₜ* and a temperature *Tₜ* of the first battery cell 111 measured at the current time t.

The second controller 122 may apply at least a part of the state data to machine learning to generate prediction data for predicting the state of the first battery cell 111. Herein, the prediction data may include a voltage *V'ₜ* of the first battery cell 111.

More specifically, the second controller 122 may predict the voltage of the first battery cell 111 by applying past data included in state data and current and temperature of the first battery cell 111 measured at the current time and included in the state data to a machine learning model of a time-series analysis structure. The time series may be defined as an order of arrangement at specific time intervals over time. The machine learning model of the time-series analysis structure may include a long short term memory (LSTM) algorithm. The LSTM algorithm, which is one of artificial neural networks, may be defined as a structure in which a recurrent neural network (RNN) is modified to reflect a long term feature. The LSTM algorithm is mainly applied to problems of time-series data showing a change over time. The LSTM algorithm may predict (n+1)th data for measurement time-series data of an object having a length of n.

The second controller 122 may predict the voltage *V'ₜ* of the first battery cell 111 at the current time t by applying voltage, current, and temperature and SOH data of the first battery cell 111 from the time (t-N) to the time (t-1) and current data and temperature data of the first battery cell 111 measured at the current time t to the LSTM algorithm. That is, the second controller 122 may generate prediction data for predicting the voltage of the first battery cell 111 at the current time t by applying state data of the first battery cell 111 from the time (t-N) to the time (t-1) to the LSTM algorithm.

The second controller 122 may determine the state of the first battery cell 111 by comparing the prediction data with the state data. More specifically, the second controller 122 may generate an anomaly score by applying the predicted voltage *V'ₜ* of the first battery cell 111 at the time t and the measured voltage *Vₜ* of the first battery cell 111 at the time t to an anomaly detection algorithm, thus to analyze an anomaly state of the battery. Herein, the anomaly detection algorithm may be defined as an artificial intelligence model that analyzes an anomaly score of an entity showing a pattern and a feature different from data prescribed as being normal.

That is, the second controller 122 may generate an anomaly score that is a difference between the predicted voltage *V'ₜ* of the first battery cell 111 at the time t and the measured voltage *Vₜ* of the first battery cell 111 at the time t.

The second controller 122 may determine that the first battery cell 111 is in the anomaly state, when a rate of anomaly scores equal to or greater than a threshold value among anomaly scores generated for a predetermined time is equal to or greater than a specific rate. That is, when a rate of anomaly scores exceeding the threshold value among anomaly scores, generated for a predetermined time, corresponding to differences between the predicted voltages *V'ₜ* of the first battery cell 111 and the measured voltages *Vₜ* of the first battery cell 111, is maintained for several seconds to several tens of seconds, then the second controller 122 may determine the first battery cell 111 to be in the anomaly state.

When the first battery cell 111 is determined to be in the anomaly state, the second controller 122 may compress state data obtained for a predetermined time before and after when the first battery cell 111 is determined to be in the anomaly state.

The communication unit 123 may transmit state data to a server 200 based on a result of determining, by the second controller 122, the state of the first battery cell 111. That is, when the first battery cell 111 is determined to be in the anomaly state, the communication unit 123 may transmit the compressed state data of the first battery cell 111 to the server 200 using an over-the-air (OTA) technique. Herein, the OTA technique, which is one of firmware update schemes, may be defined as a technique for wirelessly updating firmware using Wireless Fidelity (Wi-Fi), etc., without connection to a computer.

As such, with the battery management apparatus 120 and a battery testing system 1000 according to an embodiment disclosed herein, when the battery is determined to be in the anomaly state, battery data is transmitted to the server, thereby improving diagnosis efficiency of the battery management apparatus 120 and preventing unnecessary power supply of the battery management apparatus 120.

The battery management apparatus 120 and the battery testing system 1000 analyze first battery data by using a voltage prediction model designed in the battery management apparatus and transmit the battery data to a server having rich computing resources in the vent of detection of an anomaly phenomenon for precise analysis, thereby precisely analyzing the anomaly phenomenon of the battery and innovatively reducing data transmitted to the server, such that a communication resource may be reduced and storage and computing capabilities of a cloud computer included in the server may be lightened.

The battery management apparatus 120 and the battery testing system 1000 may transmit necessary minimum battery data to the server without a data loss to reduce infrastructure investment cost and network cost of the server.

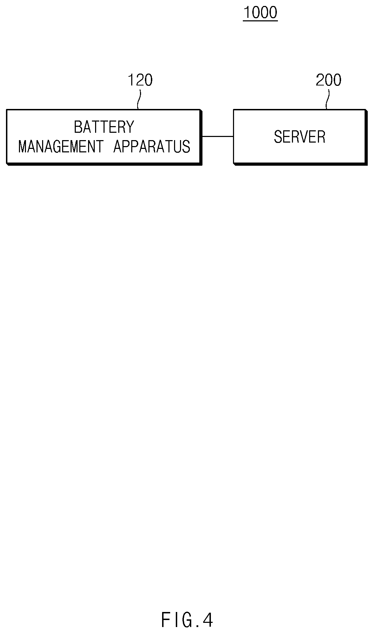

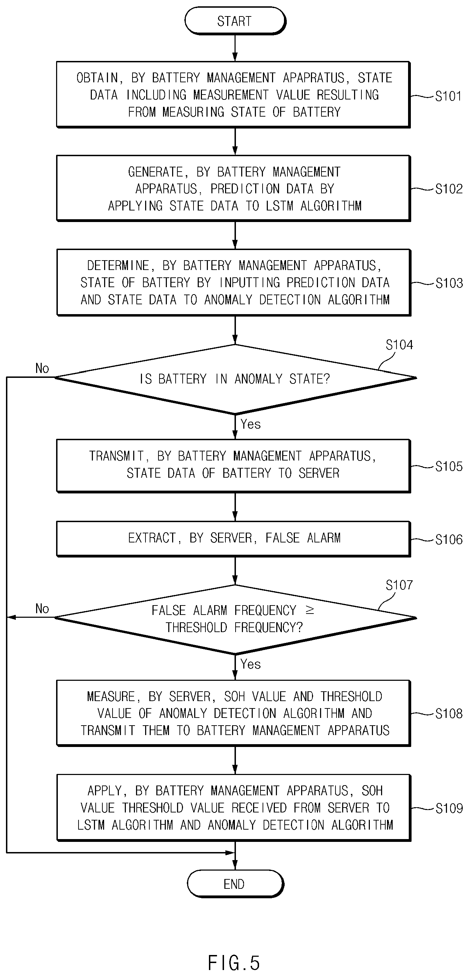

FIG. 4 is a block diagram illustrating a configuration of a battery testing system according to an embodiment disclosed herein. FIG. 5 is a flowchart illustrating an operating method of a battery testing system according to an embodiment disclosed herein.

Hereinbelow, referring to FIGS. 4 and 5, a configuration and an operation of the battery testing system 1000 will be described.

Referring to FIG. 4, the battery testing system 1000 according to an embodiment disclosed herein may include the battery management apparatus 120 and the server 200.

The battery management apparatus 120 may be substantially the same as the battery management apparatus 120 described with reference to FIGS. 1 to 3, and thus will be briefly described to avoid redundant description.

Referring to FIG. 5, an operating method of a battery testing system operation S101 of obtaining, by the battery management apparatus 120, state data including a measurement value resulting from measuring the state of the first battery cell 111, operation S102 of generating, by the battery management apparatus 120, prediction data by applying the state data to an LSTM algorithm, operation S103 of determining, by the battery management apparatus 120, the state of the first battery cell 111 by inputting the prediction data and the state data to an anomaly detection algorithm, operation S104 of determining, by the battery management apparatus 120, whether the first battery cell 111 is in an anomaly state, operation S105 of transmitting, by the battery management apparatus 120, the state data of the first battery cell 111 when the first battery cell 111 is in the anomaly state, operation S106 of extracting, by the server 200, false alarm, operation S107 of determining, by the server 200, whether a frequency of the false alarm is equal to or greater than a threshold frequency, operation S108 of measuring, by the server 200, an SOH value of the first battery cell 111 and the threshold value of the anomaly detection algorithm and transmitting the SOH and the threshold value to the battery management apparatus 120 when the frequency of the false alarm is equal to or greater than the threshold frequency, and operation S109 of applying, by the battery management apparatus 120, the SOH value and the threshold value received from the server 200 to the LSTM algorithm and the anomaly detection algorithm.

Hereinbelow, operations S101 through S109 will be described in detail.

In operation S101, the battery management apparatus 120 may obtain state data including a measurement value resulting from measuring the state of the first battery cell 111. Herein, the state data may include the measurement value including the measured voltage, current, and temperature of the first battery cell 111 and an SOH of the first battery cell 111 calculated based on the measurement value. That is, the battery management apparatus 120 may obtain past state data of the first battery cell 111 from the time (t-N) to the time (t-1). The battery management apparatus 120 may obtain a measurement value of a current and a temperature of the first battery cell 111 measured at the current time t.

In operation S101, the battery management apparatus 120 may apply at least a part of the state data to machine learning to generate prediction data for predicting the state of the first battery cell 111.

For example, in operation S101, the battery management apparatus 120 may predict the voltage *V'ₜ* of the first battery cell 111 at the current time t by applying voltage, current, and temperature and SOH data of the first battery cell 111 from the time (t-N) to the time (t-1) and current data and temperature data of the first battery cell 111 measured at the current time t to the LSTM algorithm.

In operation S103, the battery management apparatus 120 may determine the state of the first battery cell 111 by comparing the prediction data with the state data. More specifically, the battery management apparatus 120 may generate an anomaly score by applying the predicted voltage *V'ₜ* of the first battery cell 111 at the time t and the measured voltage *Vₜ* of the first battery cell 111 at the time t to an anomaly detection algorithm, thus to analyze an anomaly state of the battery.

In operation S104, the battery management apparatus 120 may determine that the first battery cell 111 is in the anomaly state, when a rate of anomaly scores equal to or greater than a threshold value among anomaly scores generated for a predetermined time is equal to or greater than a specific rate.

In operation S105, when the first battery cell 111 is determined to be in the anomaly state, the battery management apparatus 120 may compress state data obtained for a predetermined time before and after when the first battery cell 111 is determined to be in the anomaly state, and transmit the compressed state data to the server 200.

The server 200 may be defined as a determining apparatus that receives the state data of the first battery cell 111 and determines whether the first battery cell 111 is defective. The server 200 may include, for example, a cloud computing technique.

The server 200 may include an artificial intelligence model that extracts false alarm corresponding to a case where the first battery cell 111 is determined to be in the anomaly state based on the state data of the first battery cell 111 determined by the battery management apparatus 120 even though the first battery cell 111 is not actually in the anomaly state.

In operation S106, when the battery management apparatus 120 compresses the state data of the first battery cell 111 obtained for a predetermined time before and after when the battery management apparatus 120 is determined in the anomaly state, and transmits the compressed state data to the server 200, the server 200 may receive the compressed state data transmitted from the battery management apparatus 120.

In operation S106, the server 200 may analyze the compressed data received from the battery management apparatus 120, that is, the state data obtained for the predetermined time before and after the determination as the anomaly state to extract false alarm corresponding to the case where the first battery cell 111 is determined to be in the anomaly state even though the first battery cell 111 is not actually in the anomaly state.

In operation S107, the server 200 may determine whether a frequency of the false alarm is equal to or greater than a threshold frequency.

In operation S108, when the frequency of the false alarm is equal to or greater than the threshold frequency, the server 200 may recalculate an SOH value of the first battery cell 111 included in the battery management apparatus 120 and reset a threshold value of an anomaly detection algorithm for transmission to the battery management apparatus 120.

That is, in operation S108, the server 200 may analyze a cause for occurrence of the false alarm of the first battery cell 111 as the SOH value of the first battery cell 111 and the threshold value of the anomaly detection algorithm, input to the LSTM algorithm of the battery management apparatus 120.

The LSTM algorithm of the battery management apparatus 120 may receive, as past data included in the state data of the first battery cell 111, a measurement value resulting from measuring voltage, current, and temperature of the first battery cell 111 and an SOH value of the first battery cell 111 based on the measurement value. Thus, when an error occurs in a process of calculating, by the battery management apparatus 120, the voltage, current, and temperature of the first battery cell 111 and the SOH value of the first battery cell 111, an error may occur in the LSTM algorithm and this error may cause false alarm of the battery testing system 1000. Thus, the server 200 may recalculate the SOH value of the first battery cell 111 input to the battery management apparatus 120 and transmit the recalculated SOH value to the battery management apparatus 120.

In operation S108, the server 200 may analyze a cause for occurrence of the false alarm of the first battery cell 111 as the threshold value of the anomaly detection algorithm of the battery management apparatus 120.

The battery management apparatus 120 may generate an anomaly score that is a difference between the predicted voltage *V*'*ₜ* of the first battery cell 111 at the time t and the measured voltage *Vₜ* of the first battery cell 111 at the time t by using the anomaly detection algorithm, and determine the first battery cell 111 to be in the anomaly state when a rate of anomaly scores greater than a threshold value among generated anomaly scores is greater than a specific rate. Thus, when the threshold value for determining, by the battery management apparatus 120, the anomaly score as an abnormal value is not appropriate, an error may occur for the battery management apparatus 120 to determine the anomaly state of the first battery cell 111, and this error may cause false alarm of the battery testing system 1000. Thus, the server 200 may reset the threshold value of the anomaly detection algorithm input to the battery management apparatus 120 and transmit the reset threshold value to the battery management apparatus 120.

In operation S109, when the battery management apparatus 120 receives the SOH value of the first battery cell 111 and the threshold value of the anomaly detection algorithm from the server 200, the battery management apparatus 120 may update the LSTM algorithm and the anomaly detection algorithm.

The above description is merely illustrative of the technical idea of the present disclosure, and various modifications and variations will be possible without departing from the essential characteristics of the present disclosure by those of ordinary skill in the art to which the present disclosure pertains.

Therefore, the embodiments disclosed in the present invention are intended for description rather than limitation of the present disclosure

## Claims

1. A battery management apparatus (120) comprising:
a first controller (121) configured
to obtain state data (Vₜ, Iₜ, Tₜ, SOH) comprising a measurement value (Vₜ, Iₜ, Tₜ) resulting from measuring a state of a battery (110);
a second controller (122) configured
to generate prediction data (Vt') for predicting the state of the battery (110) by applying measurement values in past times (t-N, ..., t-1) and at least a part of measurement values in a current time (t) of the state data (Vₜ, Iₜ, Tₜ, SOH) to machine learning and
to determine the state of the battery (110) based on a result of comparing the prediction data (Vt') with the state data (Vₜ) of the battery (110);
**characterised by**
a communication unit (123) configured
to transmit the state data (Vₜ, It, Tₜ, SOH) to a server (200) only in case that the battery (110) is determined to be in an anomaly state based on a result of determining the state of the battery (110).

2. The battery management apparatus (120) of claim 1, wherein the second controller (122) is further configured to compress the state data (Vₜ, It, Tt, SOH) obtained for a predetermined time before and after when the battery (110) is determined to be in the anomaly state, in case that the battery (110) is determined to be in the anomaly state.

3. The battery management apparatus (120) of claim 2, wherein the communication unit (123) is further configured to transmit the compressed state data (Vt, Iₜ, Tₜ, SOH) of the battery (110) to the server (200).

4. The battery management apparatus (120) of claim 1, wherein the measurement value (Vₜ, It, Tₜ) comprises voltage (Vₜ), current (It), and temperature (Tₜ) of the battery (110), which are measured cumulatively, and the state data (Vₜ, Iₜ, Tₜ, SOH) comprises the measurement value (Vₜ, Iₜ, Tt) and a state of health (SOH) of the battery (110), calculated based on the measurement value (Vₜ, It, Tₜ).

5. The battery management apparatus (120) of claim 4, wherein the prediction data (Vt') comprises a voltage of the battery (110), and
the second controller (122) is further configured to predict the voltage (Vₜ) of the battery (110) by applying past data included in the state data (Vₜ, Iₜ, Tt, SOH) and current (It) and temperature (Tₜ) of the battery (110), which are included in the state data (Vt, Iₜ, Tₜ, SOH) and measured at current time (t), to a machine learning model.

6. The battery management apparatus (120) of claim 5, wherein the second controller (122) is further configured to predict the voltage (Vt) of the battery (110) by applying the state data (Vₜ, It, Tₜ, SOH) to a long short term memory (LSTM) algorithm.

7. The battery management apparatus (120) of claim 4, wherein the second controller (122) is further configured to generate an anomaly score (Vₜ - Vₜ') by applying the state data (Vₜ) and the prediction data (Vt') to an anomaly detection algorithm.

8. The battery management apparatus (120) of claim 7, wherein the second controller (122) is further configured to determine the battery (110) to be in the anomaly state when a rate of anomaly scores (Vₜ - Vₜ') equal to or greater than a threshold value among anomaly values generated for a predetermined time is equal to or greater than a specific rate.

9. A battery testing system (1000) comprising:
a battery management apparatus (120) according to any one of the preceding claims; and
a server (200) configured to determine whether the battery (110) is in an anomaly state, based on the state data (Vₜ, It, Tₜ, SOH) of the battery (110).

10. The battery testing system (1000) of claim 9, wherein the battery management apparatus (120) is further configured to compress the state data (Vₜ, Iₜ, Tt, SOH) obtained for a predetermined time before and after when the battery (110) is determined to be in an anomaly state, and to transmit the compressed state data (Vt, Iₜ, Tₜ, SOH) to the server (200), in case that the battery (110) is determined to be in the anomaly state.

11. The battery testing system (1000) of claim 9, wherein the measurement value (Vₜ, Iₜ, Tₜ) comprises voltage (Vₜ), current (Iₜ), and temperature (Tₜ) of the battery (110), which are measured cumulatively, and the state data (Vₜ, Iₜ, Tₜ, SOH) comprises the measurement value (Vₜ, Iₜ, Tₜ) and a state of health (SOH) of the battery (110), calculated based on the measurement value (Vₜ, It, Tₜ).

12. The battery testing system (1000) of claim 11, wherein the battery management apparatus (120) is further configured to predict the voltage (Vt) of the battery (110) by applying past data included in the state data (Vₜ, It, Tₜ, SOH) and current (It) and temperature (Tₜ) of the battery (110), which are included in the state data (Vt, Iₜ, Tₜ, SOH) and measured at current time (t), to a long short term memory (LSTM) algorithm.

13. The battery testing system (1000) of claim 11, wherein the battery management apparatus (120) is further configured to generate an anomaly score (Vₜ - Vₜ') by applying the state data (Vₜ) and the prediction data (Vt') to an anomaly detection algorithm, and to determine the battery (110) to be in the anomaly state when a rate of anomaly scores (Vₜ - Vₜ') equal to or greater than a threshold value among anomaly values generated for a predetermined time is equal to or greater than a specific rate.

14. The battery testing system (1000) of claim 13, wherein the server (200) is further configured to extract false alarm when the battery (110) is determined to be in the anomaly state in the battery management apparatus (120) even though the battery (110) is not actually in the anomaly state.

15. The battery testing system (1000) of claim 14, wherein the server (200) is further configured to measure the SOH value of the battery (110) and the threshold value of the anomaly detection algorithm and to transmit the SOH value and the threshold value to the battery management apparatus (120), when a frequency of the false alarm is equal to or greater than a threshold frequency.

## Patentansprüche

1. Batterieverwaltungsvorrichtung (120) aufweisend:
eine erste Steuereinheit (121), die konfiguriert ist,
Zustandsdaten (Vₜ, It, Tₜ, SOH) zu erhalten, die einen Messwert (Vt, It, Tₜ) aufweisen, der aus Messen eines Zustands einer Batterie (110) resultiert;
eine zweite Steuereinheit (122), die konfiguriert ist,
Vorhersagedaten (Vt') zum Vorhersagen des Zustands der Batterie (110) durch Anwenden von Messwerten in vergangenen Zeiten (t-N, ..., t-1) und zumindest eines Teils von Messwerten in einer aktuellen Zeit (t) der Zustandsdaten (Vt, It, Tₜ, SOH) auf maschinelles Lernen zu erzeugen, und
den Zustand der Batterie (110) basierend auf einem Ergebnis des Vergleichens der Vorhersagedaten (Vt') mit den Zustandsdaten (Vₜ) der Batterie (110) zu bestimmen,
**gekennzeichnet durch**
eine Kommunikationseinheit (123), die konfiguriert ist, die Zustandsdaten (Vₜ, It, Tt, SOH) nur dann an einen Server (200) zu übertragen, wenn basierend auf einem Ergebnis des Bestimmens des Zustands der Batterie (110) festgestellt wird, dass sich die Batterie (110) in einem Anomaliezustand befindet.

2. Batterieverwaltungsvorrichtung (120) nach Anspruch 1, wobei die zweite Steuereinheit (122) ferner konfiguriert ist, die Zustandsdaten (Vt, It, Tt, SOH), die für eine vorbestimmte Zeit vor und nach dem Bestimmen, dass sich die Batterie (110) in dem Anomaliezustand befindet, erhalten werden, zu komprimieren, wenn festgestellt wird, dass sich die Batterie (110) in dem Anomaliezustand befindet.

3. Batterieverwaltungsvorrichtung (120) nach Anspruch 2, wobei die Kommunikationseinheit (123) ferner konfiguriert ist, die komprimierten Zustandsdaten (Vt, It, Tt, SOH) der Batterie (110) an den Server (200) zu übertragen.

4. Batterieverwaltungsvorrichtung (120) nach Anspruch 1, wobei der Messwert (Vₜ, It, Tₜ) Spannung (Vₜ), Strom (Iₜ) und Temperatur (Tt) der Batterie (110) aufweist, die kumulativ gemessen werden, und die Zustandsdaten (Vt, It, Tₜ, SOH) den Messwert (Vt, It, Tₜ) und einen Gesundheitszustand (SOH) der Batterie (110) aufweisen, der basierend auf dem Messwert (Vt, It, Tₜ) berechnet wird.

5. Batterieverwaltungsvorrichtung (120) nach Anspruch 4, wobei die Vorhersagedaten (Vt') eine Spannung der Batterie (110) aufweisen, und
die zweite Steuereinheit (122) ferner konfiguriert ist, die Spannung (Vₜ) der Batterie (110) durch Anwenden vergangener Daten, die in den Zustandsdaten (Vt, It, Tt, SOH) enthalten sind, und Strom (It) und Temperatur (Tₜ) der Batterie (110), die in den Zustandsdaten (Vt, It, Tt, SOH) enthalten sind und zu der aktuellen Zeit (t) gemessen werden, auf ein maschinelles Lernmodell vorherzusagen.

6. Batterieverwaltungsvorrichtung (120) nach Anspruch 5, wobei die zweite Steuereinheit (122) ferner konfiguriert ist, die Spannung (Vt) der Batterie (110) durch Anwenden der Zustandsdaten (Vt, It, Tₜ, SOH) auf einen Algorithmus mit langem Kurzzeitgedächtnis (LSTM) vorherzusagen.

7. Batterieverwaltungsvorrichtung (120) nach Anspruch 4, wobei die zweite Steuereinheit (122) ferner konfiguriert ist, einen Anomaliewert (Vt - Vₜ') durch Anwenden der Zustandsdaten (Vₜ) und der Vorhersagedaten (Vt') auf einen Anomaliedetektionsalgorithmus zu erzeugen.

8. Batterieverwaltungsvorrichtung (120) nach Anspruch 7, wobei die zweite Steuereinheit (122) ferner konfiguriert ist, zu bestimmen, dass sich die Batterie (110) in dem Anomaliezustand befindet, wenn eine Rate von Anomaliewerten (Vt - Vₜ') gleich oder größer als ein Schwellenwert unter Anomaliewerten, die für eine vorbestimmte Zeit erzeugt werden, gleich oder größer als eine spezifische Rate ist.

9. Batterieprüfsystem (1000) aufweisend:
eine Batterieverwaltungsvorrichtung (120) nach einem der vorhergehenden Ansprüche; und
einen Server (200), der konfiguriert ist, basierend auf den Zustandsdaten (Vt, It, Tt, SOH) der Batterie (110) zu bestimmen, ob sich die Batterie (110) in einem Anomaliezustand befindet.

10. Batterieprüfsystem (1000) nach Anspruch 9, wobei die Batterieverwaltungsvorrichtung (120) ferner konfiguriert ist, die Zustandsdaten (Vt, It, Tt, SOH), die für eine vorbestimmte Zeit vor und nach dem Bestimmen, dass sich die Batterie (110) in einem Anomaliezustand befindet, erhalten werden, zu komprimieren, und die komprimierten Zustandsdaten (Vt, It, Tₜ, SOH) an den Server (200) zu übertragen, wenn festgestellt wird, dass sich die Batterie (110) in dem Anomaliezustand befindet.

11. Batterieprüfsystem (1000) nach Anspruch 9, wobei der Messwert (Vt, It, Tₜ) Spannung (Vₜ), Strom (It) und Temperatur (Tₜ) der Batterie (110) aufweist, die kumulativ gemessen werden, und die Zustandsdaten (Vₜ, It, Tt, SOH) den Messwert (Vt, It, Tₜ) und einen Gesundheitszustand (SOH) der Batterie (110) aufweisen, der basierend auf dem Messwert (Vt, It, Tₜ) berechnet wird.

12. Batterieprüfsystem (1000) nach Anspruch 11, wobei die Batterieverwaltungsvorrichtung (120) ferner konfiguriert ist, die Spannung (Vt) der Batterie (110) durch Anwenden vergangener Daten, die in den Zustandsdaten (Vt, It, Tt, SOH) enthalten sind, und Strom (It) und Temperatur (Tₜ) der Batterie (110), die in den Zustandsdaten (Vt, It, Tt, SOH) enthalten sind und zu der aktuellen Zeit (t) gemessen werden, auf einen Algorithmus mit langem Kurzzeitgedächtnis (LSTM) vorherzusagen.

13. Batterieprüfsystem (1000) nach Anspruch 11, wobei die Batterieverwaltungsvorrichtung (120) ferner konfiguriert ist, einen Anomaliewert (Vt - Vₜ') durch Anwenden der Zustandsdaten (Vₜ) und der Vorhersagedaten (Vt') auf einen Anomaliedetektionsalgorithmus zu erzeugen, und zu bestimmen, dass sich die Batterie (110) in dem Anomaliezustand befindet, wenn eine Rate von Anomaliewerten (Vt - Vₜ') gleich oder größer als ein Schwellenwert unter Anomaliewerten, die für eine vorbestimmte Zeit erzeugt werden, gleich oder größer als eine spezifische Rate ist.

14. Batterieprüfsystem (1000) nach Anspruch 13, wobei der Server (200) ferner konfiguriert ist, einen Fehlalarm zu extrahieren, wenn in der Batterieverwaltungsvorrichtung (120) bestimmt wird, dass sich die Batterie (110) in dem Anomaliezustand befindet, obwohl sich die Batterie (110) in Wirklichkeit nicht in dem Anomaliezustand befindet.

15. Batterieprüfsystem (1000) nach Anspruch 14, wobei der Server (200) ferner konfiguriert ist, den SOH-Wert der Batterie (110) und den Schwellenwert des Anomaliedetektionsalgorithmus zu messen und den SOH-Wert und den Schwellenwert an die Batterieverwaltungsvorrichtung (120) zu übertragen, wenn eine Frequenz des Fehlalarms gleich oder größer als eine Schwellenfrequenz ist.

## Revendications

1. Appareil de gestion de batterie (120) comprenant :
une première unité de commande (121) configurée
pour obtenir des données d'état (Vt, It, Tt, SOH) comprenant une valeur de mesure (Vₜ, It, Tt) résultant de la mesure d'un état d'une batterie (110) ;
une deuxième unité de commande (122) configurée
pour générer des données de prévision (Vt') pour prédire l'état de la batterie (110) en appliquant des valeurs de mesure dans des temps passés (t-N, ..., t-1) et au moins une partie des valeurs de mesure dans un temps actuel (t) des données d'état (Vt, It, Tt, SOH) à un apprentissage automatique et
pour déterminer l'état de la batterie (110) sur la base d'un résultat de comparaison des données de prévision (Vt') avec les données d'état (Vt) de la batterie (110) ;
**caractérisé par**
une unité de communication (123) configurée
pour transmettre les données d'état (Vt, It, Tt, SOH) à un serveur (200) seulement dans le cas où la batterie (110) est déterminée être dans un état d'anomalie sur la base d'un résultat de détermination de l'état de la batterie (110).

2. Appareil de gestion de batterie (120) selon la revendication 1, dans lequel la deuxième unité de commande (122) est configurée en outre pour compresser les données d'état (Vt, It, Tt, SOH) obtenues pendant un temps prédéterminé avant et après que la batterie (110) est déterminée être dans l'état d'anomalie, dans le cas où la batterie (110) est déterminée être dans l'état d'anomalie.

3. Appareil de gestion de batterie (120) selon la revendication 2, dans lequel l'unité de communication (123) est configurée en outre pour transmettre les données d'état compressées (Vₜ, It, Tt, SOH) de la batterie (110) au serveur (200).

4. Appareil de gestion de batterie (120) selon la revendication 1, dans lequel la valeur de mesure (Vt, It, Tt) comprend la tension (Vt), le courant (It) et la température (Tt) de la batterie (110), qui sont mesurées cumulativement, et les données d'état (Vₜ, It, Tt, SOH) comprennent la valeur de mesure (Vt, It, Tt) et un état de santé, (State de Health (SoH)) de la batterie (110), calculé sur la base de la valeur de mesure (Vt, It, Tt).

5. Appareil de gestion de batterie (120) selon la revendication 4, dans lequel les données de prévision (Vt') comprennent une tension de la batterie (110), et
la deuxième unité de commande (122) est configurée en outre pour prédire la tension (Vt) de la batterie (110) en appliquant des données passées inclues dans les données d'état (Vt, It, Tt, SOH) et le courant (It) et la température (Tt) de la batterie (110), qui sont inclus dans les données d'état (Vₜ, It, Tt, SOH) et mesurés en temps actuel (t), à un modèle d'apprentissage automatique.

6. Appareil de gestion de batterie (120) selon la revendication 5, dans lequel la deuxième unité de commande (122) est configurée en outre pour prédire la tension (Vt) de la batterie (110) en appliquant les données d'état (Vt, It, Tt, SOH) à un algorithme de mémoire à court et long terme (LSTM).

7. Appareil de gestion de batterie (120) selon la revendication 4, dans lequel la deuxième unité de commande (122) est configurée en outre pour générer un score d'anomalie (Vₜ - Vₜ') en appliquant les données d'état (Vt) et les données de prévision (Vt') à un algorithme de détection d'anomalies.

8. Appareil de gestion de batterie (120) selon la revendication 7, dans lequel la deuxième unité de commande (122) est configurée en outre pour déterminer que la batterie (110) est dans l'état d'anomalie quand un taux de score d'anomalies (Vₜ - Vₜ') égal ou supérieur à une valeur de seuil parmi des valeurs d'anomalie générées pendant un temps prédéterminé est égal ou supérieur à un taux spécifique.

9. Système de test de batterie (1000) comprenant :
un appareil de gestion de batterie (120) selon l'une quelconque des revendications précédentes ; et
un serveur (200) configuré pour déterminer si la batterie (110) est dans un état d'anomalie, sur la base des données d'état (Vₜ, It, Tt, SOH) de la batterie (110).

10. Système de test de batterie (1000) selon la revendication 9, dans lequel l'appareil de gestion de batterie (120) est configuré en outre pour compresser les données d'état (Vt, It, Tt, SOH) obtenues pendant un temps prédéterminé avant et après que la batterie (110) est déterminée être dans un état d'anomalie, et pour transmettre les données d'état compressées (Vt, It, Tt, SOH) au serveur (200), dans le cas où la batterie (110) est déterminée être dans l'état d'anomalie.

11. Système de test de batterie (1000) selon la revendication 9, dans lequel la valeur de mesure (Vt, It, Tt) comprend la tension (Vt), le courant (It) et la température (Tt) de la batterie (110), qui sont mesurés cumulativement, et les données d'état (Vₜ, Iₜ, Tt, SOH) comprennent la valeur de mesure (Vt, It, Tt) et un état de santé, (State de Health (SoH)) de la batterie (110), calculé sur la base de la valeur de mesure (Vt, It, Tt).

12. Système de test de batterie (1000) selon la revendication 11, dans lequel l'appareil de gestion de batterie (120) est configuré en outre pour prédire la tension (Vt) de la batterie (110) en appliquant des données passées inclues dans les données d'état (Vt, It, Tt, SOH) et le courant (It) et la température (Tt) de la batterie (110), qui sont inclus dans les données d'état (Vt, It, Tt, SOH) et mesurés en temps actuel (t), à un algorithme de mémoire à court et long terme (LSTM).

13. Système de test de batterie (1000) selon la revendication 11, dans lequel l'appareil de gestion de batterie (120) est configuré en outre pour générer un score d'anomalie (Vt - Vₜ') en appliquant les données d'état (Vt) et les données de prévision (Vt') à un algorithme de détection d'anomalies, et pour déterminer que la batterie (110) est dans l'état d'anomalie quand un taux de score d'anomalies (Vt - Vₜ') égal ou supérieur à une valeur de seuil parmi des valeurs d'anomalie générées pendant un temps prédéterminé est égal ou supérieur à un taux spécifique.

14. Système de test de batterie (1000) selon la revendication 13, dans lequel le serveur (200) est configuré en outre pour extraire une fausse alarme quand la batterie (110) est déterminée être dans l'état d'anomalie dans l'appareil de gestion de batterie (120) même quand la batterie (110) n'est pas en fait dans l'état d'anomalie.

15. Système de test de batterie (1000) selon la revendication 14, dans lequel le serveur (200) est configuré en outre pour mesurer la valeur SOH de la batterie (110) et la valeur de seuil de l'algorithme de détection d'anomalies et pour transmettre la valeur SOH et la valeur de seuil à l'appareil de gestion de batterie (120), quand une fréquence de seuil de la fausse alarme est égal ou supérieur à une fréquence de seuil.
